# EUROPEAN PATENT APPLICATION

(11) **EP 4 726 849 A1**
(43) Date of publication of application: **15.04.2026**
(21) Application number: 25193739.7
(22) Date of filing: 04.08.2025
(51) Int. Cl.: H01M 10/42

(54) **SECONDARY BATTERY TESTING DEVICE AND PENETRATING PIN ALIGNMENT MECHANISM FOR SHORT-CIRCUIT TEST OF SECONDARY BATTERY**

(30) Priority: 10.09.2024 KR 20240123571
(71) Applicant: SAMSUNG SDI CO., LTD., Yongin-si, Gyeonggi-do 17084 (KR)
(72) Inventor: KIM, Hyunsung, Gyeonggi-do 17084 (KR); LEE, Sangik, Gyeonggi-do 17084 (KR); PARK, Jongtaek, Gyeonggi-do 17084 (KR); KIM, Jin, Gyeonggi-do 17084 (KR)
(74) Representative: Gulde & Partner

(57) **Abstract**

A secondary battery testing device including: a support bulkhead configured to contact one side surface of a battery cell for an internal short-circuit test; a penetration bulkhead opposite to the support bulkhead and configured to contact an opposite side surface of the battery cell, the penetration bulkhead having an access opening extending therethrough toward the support bulkhead; a bulkhead connector connecting the support bulkhead and the penetration bulkhead to each other and maintaining a gap between the support bulkhead and the penetration bulkhead; an alignment mechanism mounted on the penetration bulkhead and having a nail guide corresponding to the access opening and having a guide passage; and a nail configured to penetrate the battery cell through the guide passage to cause an electrical short-circuit of the battery cell.

## Description

### BACKGROUND

### 1. Field

Aspects of embodiment of the present disclosure relate to a secondary battery testing device and a penetrating pin alignment mechanism for a short-circuit test of a secondary battery.

### 2. Description of Related Art

Different from primary batteries that are not designed to be charged, secondary batteries are designed to be charged and discharged. Generally, a secondary battery includes an electrode assembly including (or formed of) electrode plates including positive and negative electrodes, a case that accommodates the electrode assembly, an electrode terminal connected to the electrode assembly, a vent for degassing excess gas generated inside the case, and the like.

Recently, secondary batteries used for driving motors and used as power storage in hybrid vehicles, electric vehicles, and the like have been increasing in capacity. Large-capacity batteries have a particularly high demand for safety. For example, in the case of electric vehicles, there may be accidents in which an external object damages a battery case and permeates or penetrates the electrode assembly therein. In this case, the negative electrode may contact the positive electrode in the electrode assembly, which causes a very high short-circuit current to flow therebetween, causing overheating, thermal runaway, and/or explosion of the battery.

In view of such demands for the safety of secondary batteries, penetration safety is included among secondary battery safety evaluation items, and a penetration test is often conducted on secondary batteries. A secondary battery penetration test includes, after a secondary battery is charged, a nail hitting electrode plates of an electrode assembly to partially penetrate or completely penetrate the electrode plates.

When the penetration test is conducted, penetration test noise may occur due to misalignment of the battery and the nail. The penetration test noise can significantly lower the accuracy of the penetration test.

The above information disclosed in this Background section is for enhancement of understanding of the background of the present disclosure, and therefore, it may contain information that does not constitute a related (or prior) art.

### SUMMARY

Embodiments of the present disclosure provide a secondary battery testing device and a penetration pin alignment mechanism for a short-circuit test of a secondary battery, which enable an accurate safety evaluation by avoiding (or solving) misalignment in a penetration evaluation device during a penetration evaluation of a battery.

A secondary battery testing device, according to an embodiment of the present disclosure, includes a support bulkhead configured to contact one side surface of a battery cell for an internal short-circuit test, a penetration bulkhead opposite to the support bulkhead and configured to contact another side surface of the battery cell, the penetration bulkhead having an access opening facing the support bulkhead, a bulkhead connector connecting the support bulkhead and the penetration bulkhead and maintaining a gap between the support bulkhead and the penetration bulkhead, an alignment mechanism on the penetration bulkhead and having a nail guide corresponding to the access opening and providing a guide passage, and a nail configured to enter the battery cell through the guide passage to cause an electrical short-circuit of the battery cell.

The penetration bulkhead may have a right-position recess configured to accommodate the alignment mechanism, the access opening being formed in an internal area of the right-position recess.

The right-position recess may be a groove having an inner diameter, and the access opening may be at a center of a bottom portion of the right-position recess and be configured to allow the nail guide to pass therethrough.

The alignment mechanism may further comprise a body accommodated in the right-position recess and having the nail guide at a central portion thereof.

The nail guide may be configured to press an electrode plate of the battery cell in a state in which the nail guide passes through the access opening and an open hole in the battery cell.

An end portion of the nail guide may be formed as a pressing tip configured to press the electrode plate.

The alignment mechanism may be detachably coupled to the right-position recess or be permanently fixed to the right-position recess.

The alignment mechanism may further comprise an insert guide configured to guide insertion of the nail into the guide passage.

The nail may comprise a nail main body extending in a longitudinal direction and a nail holder fixedly accommodating an end portion of the nail main body.

The nail holder may comprise at an inner side thereof, a screw head fixed to the end portion of the nail main body and a male screw thread formed thereon, and the nail holder may be a hollow member extending in the longitudinal direction of the nail main body and have a female screw portion screw-coupled to the screw head.

A penetration pin alignment mechanism for a secondary battery short-circuit test, according to another embodiment of the present disclosure, contacts a battery cell for an internal short-circuit test and is mounted on a penetration bulkhead having an access opening therein to face the battery cell and includes a nail guide corresponding to the access opening and having a linearly extended guide passage and a body accommodating and supporting the nail guide.

The penetration bulkhead may have a right-position recess having a diameter, the access opening being at a center of a bottom surface of the right-position recess, the body may be fixedly accommodated in the right-position recess (35a), and
the nail guide may extend into the battery cell (15) through the access opening and an open hole in the battery cell.

A heat dissipation passage may be formed between the body (43) and the nail guide.

An end portion of the nail guide may hasvea pressing tip for pressing an electrode plate inside the battery cell.

The penetration pin alignment mechanism may further comprise an insert guide configured to guide insertion of a nail into the nail guide.

Aspects and features of the present disclosure are not limited to those described above, and other aspects and features not specifically mentioned herein will be clearly understood by those skilled in the art from the description of the present disclosure below.

### BRIEF DESCRIPTION OF THE DRAWINGS

The above and other aspects and features of the present disclosure will become more apparent to those of ordinary skill in the art by describing embodiments thereof, in detail, with reference to the accompanying drawings, in which:
FIG. 1 is a top perspective view of the exterior of a prismatic battery cell to be tested by using a testing device according to one embodiment of the present disclosure;
FIG. 2 is a cross-sectional view taken along the line A-A in FIG. 1;
FIG. 3 is a perspective view of a battery module in which the battery cells shown in FIG. 1 are arranged;
FIG. 4 is a perspective view of a secondary battery pack including a secondary battery module;
FIG. 5 is a conceptual diagram showing the secondary battery pack shown in FIG. 4 installed in a vehicle;
FIG. 6 is a perspective view showing a secondary battery testing device according to one embodiment of the present disclosure;
FIG. 7 is an exploded perspective view of the testing device shown in FIG. 6;
FIG. 8 is a perspective view showing a penetration pin alignment mechanism for a short-circuit test according to one embodiment of the present disclosure;
FIG. 9 is a front view of an alignment mechanism shown in FIG. 8;
FIG. 10 is a cross-sectional view taken along the line D-D in FIG. 9;
FIG. 11 is a view illustrating a usage method of the secondary battery testing device according to one embodiment of the present disclosure;
FIG. 12 is a partial cutaway exploded perspective view showing a secondary battery testing device according to another embodiment of the present disclosure;
FIG. 13 is a view illustrating a usage method of the testing device shown in FIG. 12;
FIG. 14 is a view of a secondary battery testing device according to another embodiment of the present disclosure;
FIG. 15 is a cross-sectional view of a penetration bulkhead shown in FIG. 14;
FIG. 16 is a cross-sectional view of a penetration pin alignment mechanism according to another embodiment of the present disclosure;
FIG. 17 is a view showing a penetration pin alignment mechanism according to another embodiment of the present disclosure;
FIG. 18 is a cross-sectional view of a nail applicable to the testing device according to one embodiment of the present disclosure; and
FIG. 19 is a cross-sectional view illustrating a usage method of the nail shown in FIG. 18.

### DETAILED DESCRIPTION

Hereinafter, embodiments of the present disclosure will be described, in detail, with reference to the accompanying drawings. The terms or words used in the present specification and claims should not be narrowly interpreted according to their general or dictionary meanings but should be interpreted as having meanings and concepts that are consistent with the technical idea of the present disclosure on the basis of the principle that an inventor can be his/her own lexicographer to appropriately define concepts of terms to describe his/her invention in the best way.

The embodiments described in this specification and the configurations shown in the drawings are only some embodiments of the present disclosure and do not represent all of the aspects, features, and embodiments of the present disclosure. Accordingly, it should be understood that there may be various equivalents and modifications that can replace or modify one or more embodiments or features therein described herein at the time of filing this application.

It will be understood that if an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, if a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" if describing embodiments of the present disclosure relates to "one or more embodiments of the present disclosure." Expressions, such as "at least one of" and "any one of," if preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," "side" , "bottom portion", "center", "central portion", and the like, may be used herein for ease of description to describe one element or feature's relationship to another element(s) or feature(s) as illustrated in the figures.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," if used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of patent rules.

References to two compared elements, features, etc. as being "the same" may mean that they are "substantially the same." Thus, the phrase "substantially the same" may include a case having a deviation that is considered low in the art, for example, a deviation of about 5% or less. In addition, if a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may contact the upper (or lower) surface of the element, and another element may also be interposed between the element and the arbitrary element located on (or under) the element.

In addition, it will be understood that if a component is referred to as being "linked," "coupled," or "connected" to another component, the elements may be directly "coupled," "linked" or "connected" to each other, or another component may be "interposed" between the components."

Throughout the specification, if "A and/or B" is stated, it means A, B or A and B, unless otherwise stated. That is, "and/or" includes any or all combinations of a plurality of items enumerated. When "C to D" is stated, it means C or more and D or less, unless otherwise specified.

The terminology used herein is for the purpose of describing embodiments of the present disclosure and is not intended to limit the present disclosure.

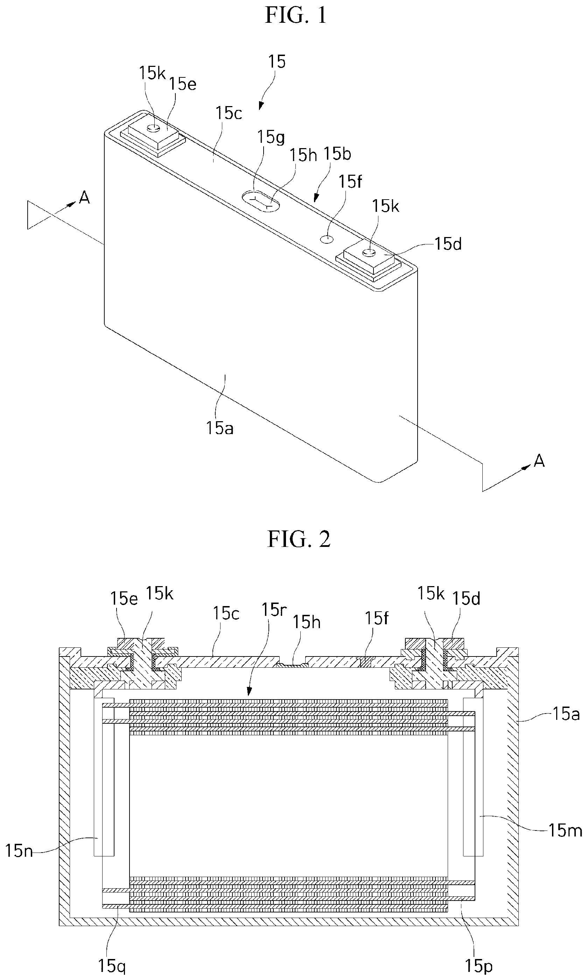

FIG. 1 is a top perspective view of an exterior of a prismatic battery cell 15 to be tested by using a testing device according to one embodiment of the present disclosure.

A case 15a defines an overall appearance of the prismatic secondary battery and may be made of (or may include) a conductive metal, such as aluminum, aluminum alloy, or nickel-plated steel. The case 15a may provide (or may form) a space for accommodating an electrode assembly therein.

A cap assembly 15b may include a cap plate 15c that covers (e.g., that seals) the opening in the case 15a. In some embodiments, the case 15a and the cap plate 15c may be made of a conductive material. A first terminal 15d and a second terminal 15e may be electrically connected to respective positive and negative (or negative and positive) electrodes inside the case 15a and may be installed such that they protrude outwardly through the cap plate 15c.

The cap plate 15c may have an electrolyte injection port 15f and a gas discharge hole (e.g., gas discharge opening) 15g. A vent (e.g., a gas discharge device) 15h may be joined to (e.g., may be installed in) the gas discharge hole 15g. The gas discharge device 15h is opened by (e.g., opens in response to) gas generated inside the case 15a and performs a degassing function.

FIG. 2 is a cross-sectional view taken along the line A-A in FIG. 1.

An electrode assembly 15r may be formed by winding or stacking a stack of a first electrode plate, a separator, and a second electrode plate, each of which are formed as thin plates or films. When the electrode assembly 15r is a wound stack, a winding axis may be parallel to the longitudinal direction of the case 15a. In other embodiments, the electrode assembly 15r is a stack type rather than a winding type, and the shape of the electrode assembly 15r is not limited in the present disclosure.

In addition, the electrode assembly 15r may be a Z-stack electrode assembly in which a positive electrode plate and a negative electrode plate are inserted into both sides (e.g., opposite sides) of a separator, which is then bent (or folded) into a Z-stack. In addition, one or more electrode assemblies 15r may be stacked such that long sides of the electrode assemblies 15r are adjacent to each other and accommodated in the case 15a, and the number of electrode assemblies 15r in the case 15a is not limited in the present disclosure. The first electrode plate of the electrode assembly 15r may act as a negative electrode, and the second electrode plate may act as a positive electrode. Of course, the reverse is also possible.

The first electrode plate may be formed by applying a first electrode active material, such as graphite, carbon, or the like, to a first electrode current collector formed of a metal foil, such as copper, a copper alloy, nickel, a nickel alloy, or the like. The first electrode plate may include a first electrode tab (e.g., a first uncoated portion) 15p, which is a region of the first electrode plate to which the first electrode active material is not applied. The first electrode tab 15p may act as a current flow path between the first electrode plate and the first current collector 15m. In some embodiments, when the first electrode plate is manufactured, the first electrode tab 15p is formed by being cut in advance to protrude to one side of the electrode assembly 15r, or the first electrode tab 15p protrudes to one side of the electrode assembly 15r more than (e.g., farther than or beyond) the separator without being separately cut.

The second electrode plate may be formed by applying a second electrode active material, such as a transition metal oxide, on a second electrode current collector formed of a metal foil, such as aluminum or an aluminum alloy. The second electrode plate may include a second electrode tab (e.g., a second uncoated portion) 15q, which is a region of the second electrode plate to which the second electrode active material is not applied. The second electrode tab 15q may act as a current flow path between the second electrode plate and the second current collector 15n. In some embodiments, the second electrode tab 15q may be formed by being cut in advance to protrude to the other side (e.g., the opposite side) of the electrode assembly when the second electrode plate is manufactured, or the second electrode plate may protrude to the other side of the electrode assembly more than (e.g., farther than or beyond) the separator without being separately cut.

The separator prevents or substantially reduces instances of a short-circuit between the first electrode and the second electrode while allowing movement of lithium ions therebetween. The separator may be made of, for example, a polyethylene film, a polypropylene film, a polyethylene-polypropylene film, or the like.

In some embodiments, the electrode assembly 15r is accommodated in the case 15a along with an electrolyte.

The first current collector 15m and the second current collector 15n of the electrode assembly 15r may be welded and connected to the first electrode tab 15p extending from the first electrode plate and the second electrode tab 15q extending from the second electrode plate, respectively.

The first current collector 15m and the second current collector 15n are connected to the first terminal 15d and the second terminal 15e through connection members 15k, respectively. In some embodiments, the connection members 15k may each have an outer peripheral surface that is threaded and may be fastened to the first terminal 15d and the second terminal 15e by screwing. However, the present disclosure is not limited thereto. For example, the connection members 15k may also be coupled to the first terminal 15d and the second terminal 15e by riveting or welding.

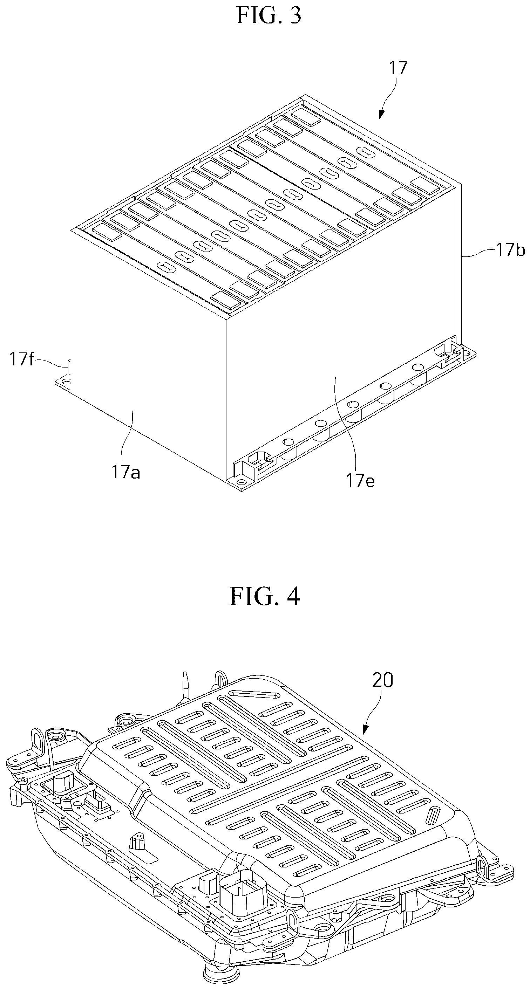

FIG. 3 is a perspective view of a secondary battery module in which secondary batteries are arranged according to embodiments of the present disclosure. With the increase in secondary battery capacity for driving electric vehicles or the like, a secondary battery module may be manufactured by arranging a plurality of secondary battery cells transversely and/or longitudinally and connecting them together. The plurality of secondary batteries may be arranged in a space defined by a pair of facing end plates 17a and 17b and a pair of facing side plates 17e and 17f. The secondary batteries may be arranged in an arrangement (e.g., a connection configuration) and number to obtain desired voltage and current specifications.

FIG. 4 is a perspective view of a battery pack 20 according to embodiments of the present disclosure. Referring to FIG. 4, the battery pack 20 may include an assembly to which individual batteries are electrically connected and a pack housing accommodating the same. In the drawings, for convenience of illustration, components such as a bus bar, a cooling unit, external terminals for electrically connecting batteries, etc., are not shown.

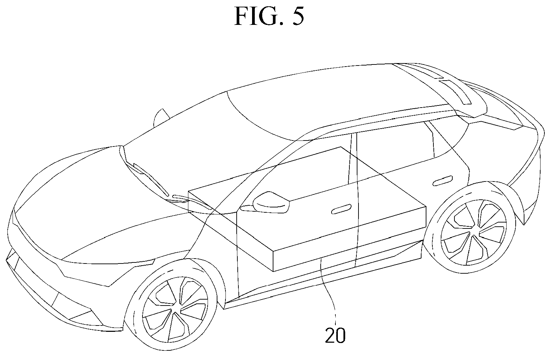

The battery pack 20 may be mounted on (or in) a vehicle. The vehicle may be, for example, an electric vehicle, a hybrid vehicle, or a plug-in hybrid vehicle. The vehicle may be a four-wheeled vehicle or a two-wheeled vehicle but is not limited thereto. FIG. 5 shows a vehicle that includes the battery pack 20 shown in FIG. 4 on the lower body thereof. The vehicle may operate by (e.g., may be powered by) receiving power from the battery pack 20.

The materials that can be used in the above secondary battery are as follows.

As the positive electrode active material, a compound capable of reversibly intercalating/deintercalating lithium (e.g., a lithiated intercalation compound) may be used. For example, at least one of a composite oxide of lithium and a metal selected from cobalt, manganese, nickel, and combinations thereof may be used.

The composite oxide may be a lithium transition metal composite oxide, and examples thereof may include a lithium nickel-based oxide, a lithium cobalt-based oxide, a lithium manganese-based oxide, a lithium iron phosphate-based compound, a cobalt-free nickel-manganese-based oxide, or a combination thereof.

As an example, a compound represented by any one of the following formulas may be used: LiₐA_{1-b}X_{b}O_{2-c}D_{c} (0.90≤a≤1.8, 0≤b≤0.5, 0≤c≤0.05); LiₐMn_{2-b}X_{b}O_{4-c}D_{c} (0.90≤a≤1.8, 0≤b≤0.5, 0≤c≤0.05); LiₐNi_{1-b-c}Co_{b}X_{c}O_{2-α}D_{α} (0.90≤a≤1.8, 0≤b≤0.5, 0≤c≤0.5, 0<α<2); LiₐNi_{1-b-c}Mn_{b}X_{c}O_{2-α}D_{α} (0.90≤a≤1.8, 0≤b≤0.5, 0≤c≤0.5, 0<α<2); LiₐNi_{b}Co_{c}L¹_{d}GₑO₂ (0.90≤a≤1.8, 0≤b≤0.9, 0≤c≤0.5, 0≤d≤0.5, 0≤e≤0.1); LiₐNiG_{b}O₂ (0.90≤a≤1.8, 0.001≤b≤0.1); LiₐCoG_{b}O₂ (0.90≤a≤1.8, 0.001≤b≤0.1); LiₐMn_{1-b}G_{b}O₂ (0.90≤a≤1.8, 0.001≤b≤0.1); LiₐMn₂G_{b}O₄ (0.90≤a≤1.8, 0.001≤b≤0.1); LiₐMn_{1-g}G_{g}PO₄ (0.90≤a≤1.8, 0≤g≤0.5); Li_{(3-f)}Fe₂(PO₄)₃ (0≤f≤2); and LiₐFePO₄ (0.90≤a≤1.8).

In the above formulas: A is Ni, Co, Mn, or a combination thereof; X is Al, Ni, Co, Mn, Cr, Fe, Mg, Sr, V, a rare earth element, or a combination thereof; D is O, F, S, P, or a combination thereof; G is Al, Cr, Mn, Fe, Mg, La, Ce, Sr, V, or a combination thereof; and L1 is Mn, Al, or a combination thereof.

A positive electrode for a lithium secondary battery may include a current collector (e.g., a substrate) and a positive electrode active material layer formed on the current collector. The positive electrode active material layer may include a positive electrode active material and may further include a binder and/or a conductive material.

The content of the positive electrode active material is in a range of about 90 wt% to about 99 wt% on the basis of 100 wt% of the positive electrode active material layer, and the content of the binder and the conductive material is in a range of about 0.5 wt% to about 5 wt%, respectively, on the basis of 100 wt% of the positive electrode active material layer.

The substrate may be aluminum (Al) but is not limited thereto.

The negative electrode active material may include a material capable of reversibly intercalating/deintercalating lithium ions, lithium metal, an alloy of lithium metal, a material capable of being doped and undoped with lithium, or a transition metal oxide.

The material capable of reversibly intercalating/deintercalating lithium ions may be a carbon-based negative electrode active material, which may include, for example, crystalline carbon, amorphous carbon, or a combination thereof. Examples of the crystalline carbon may include graphite, such as natural graphite or artificial graphite, and examples of the amorphous carbon may include soft carbon, hard carbon, a pitch carbide, a meso-phase pitch carbide, sintered coke, and the like.

A Si-based negative electrode active material or a Sn-based negative electrode active material may be used as the material capable of being doped and undoped with lithium. The Si-based negative electrode active material may be silicon, a silicon-carbon composite, SiOₓ (0 < x ≤ 2), a Si-based alloy, or a combination thereof.

The silicon-carbon composite may be a composite of silicon and amorphous carbon. According to one embodiment, the silicon-carbon composite may be in the form of a silicon particle and amorphous carbon coated on the surface of the silicon particle.

The silicon-carbon composite may further include crystalline carbon. For example, the silicon-carbon composite may include a core including crystalline carbon and silicon particle and an amorphous carbon coating layer on the surface of the core.

A negative electrode for a lithium secondary battery may include a substrate and a negative electrode active material layer disposed on the substrate. The negative electrode active material layer may include a negative electrode active material and may further include a binder and/or a conductive material.

For example, the negative electrode active material layer may include about 90 wt % to about 99 wt % of a negative electrode active material, about 0.5 wt % to about 5 wt % of a binder, and 0 wt % to about 5 wt % of a conductive material.

A non-aqueous binder, an aqueous binder, a dry binder, or a combination thereof may be used as the binder. When an aqueous binder is used as the negative electrode binder, a cellulose-based compound capable of imparting (e.g., increasing) viscosity may be further included.

As the negative electrode substrate, one selected from copper foil, nickel foil, stainless steel foil, titanium foil, nickel foam, copper foam, conductive metal-coated polymer substrate, and combinations thereof may be used.

An electrolyte for a lithium secondary battery may include a non-aqueous organic solvent and a lithium salt.

The non-aqueous organic solvent acts as a medium through which ions involved in the electrochemical reaction of the battery can move.

The non-aqueous organic solvent may be a carbonate-based, an ester-based, an ether-based, a ketone-based, an alcohol-based solvent, an aprotic solvent, and may be used alone or in combination of two or more.

In addition, when a carbonate-based solvent is used, a mixture of cyclic carbonate and chain carbonate may be used.

Depending on the type of lithium secondary battery, a separator may be present between the first electrode plate (e.g., the negative electrode) and the second electrode plate (e.g., the positive electrode). As the separator, polyethylene, polypropylene, polyvinylidene fluoride, or a multilayer film including two or more layers thereof may be used.

The separator may include a porous substrate and a coating layer including an organic material, an inorganic material, or a combination thereof on one or both surfaces of the porous substrate.

The organic material may include a polyvinylidene fluoride-based polymer or a (meth)acrylic polymer.

The inorganic material may include inorganic particles selected from Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, and combinations thereof but is not limited thereto.

The organic material and the inorganic material may be mixed in one coating layer or may be in the form of a coating layer including (or containing) an organic material and a coating layer including (or containing) an inorganic material that are stacked on each other.

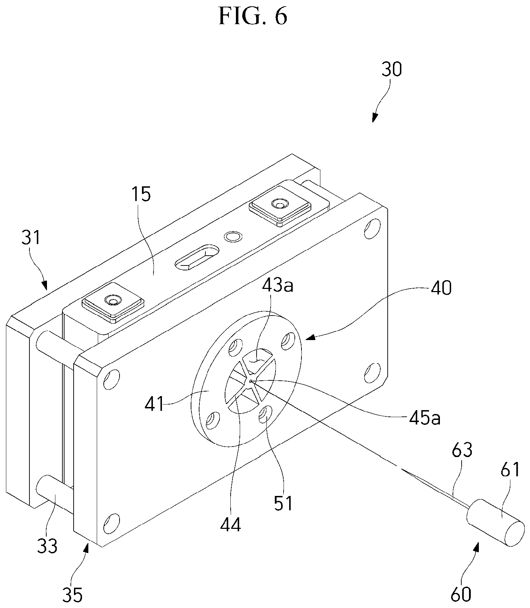

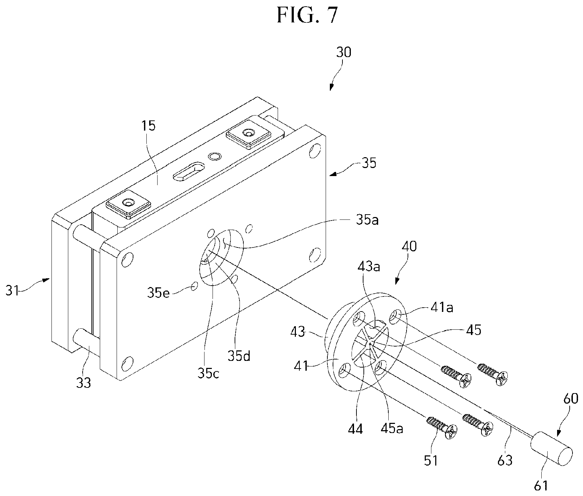

FIG. 6 is a perspective view of a secondary battery testing device 30 according to one embodiment of the present disclosure. FIG. 7 is an exploded perspective view of the testing device shown in FIG. 6.

The secondary battery testing device 30, according to the present embodiment, may include a support bulkhead 31, a penetration bulkhead 35, a bulkhead connector 33, an alignment mechanism 40, and a nail 60.

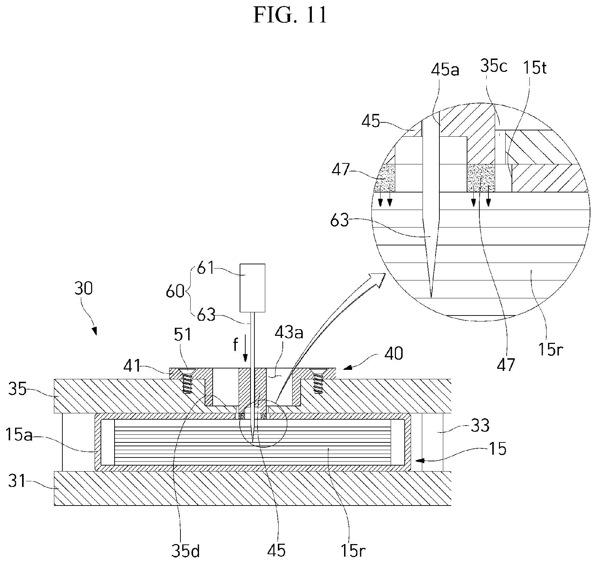

The support bulkhead 31 and the penetration bulkhead 35 may have a substantially quadrangular plate shape and may be arranged in (e.g., maintained in) a parallel state with a battery cell 15 interposed therebetween. The battery cell 15 may be a prismatic battery cell and may have an open hole 15t (see, e.g., FIG. 11) in one surface thereof. The open hole 15t is formed is for performing a penetration safety evaluation that simulates an internal short-circuit of the battery cell 15. The open hole 15t may be positioned at the center of a side portion of the battery cell 15. A diameter of the open hole 15t may vary.

The support bulkhead 31 has a predetermined thickness and is closely fixed to one side surface of the battery cell 15. The support bulkhead 31 may function to suppress swelling of the battery cell 15.

The penetration bulkhead 35 is a plate-shaped member positioned at a side opposite to the support bulkhead 31 and may have an access hole 35c. The penetration bulkhead 35 may be closely fixed to the battery cell 15. The access hole 35c may correspond to the open hole 15t as shown in FIG. 11.

A constant or substantially constant gap between the support bulkhead 31 and the penetration bulkhead 35 may be maintained by the bulkhead connector 33. The bulkhead connector 33 may connect the support bulkhead 31 with the penetration bulkhead 35 and may maintain the gap therebetween. A length (e.g., an overall or total length) of each of the four bulkhead connectors 33 may be equal to a thickness of the battery cell 15.

Referring to FIG. 7, a right-position recess 35a and a female screw hole 35e are formed in the penetration bulkhead 35. The right-position recess 35a is a circular groove having an inner diameter and depth (e.g., a predetermined inner diameter and depth) and may have an access hole (e.g., an access opening) 35c in an inner area to accommodate an alignment mechanism 40.

The access hole 35c may be positioned at the center of a bottom portion 35d of the right-position recess 35a. The access hole 35c allows an end portion of a nail guide 45 to pass therethrough as shown in, for example, FIG. 11.

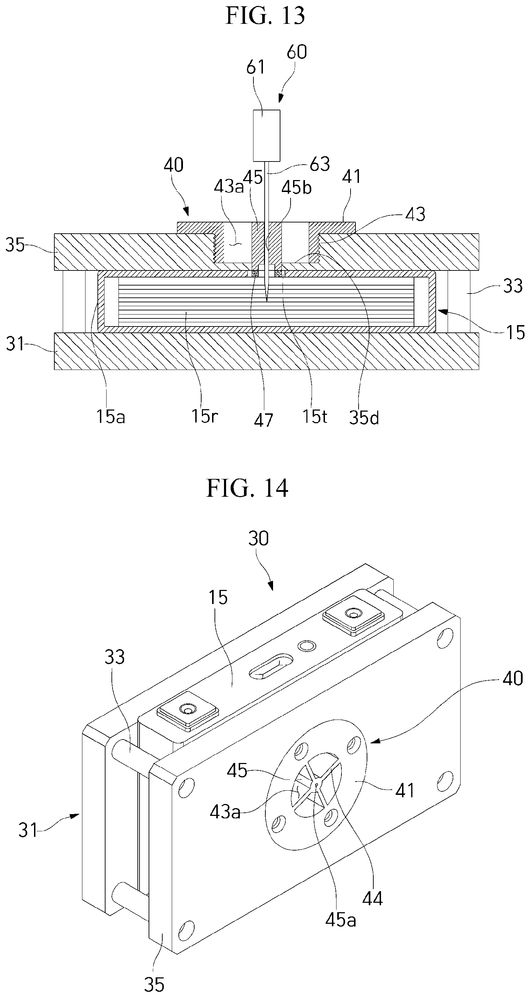

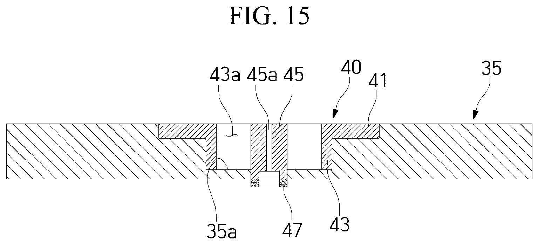

The female screw hole 35e may be disposed near the right-position recess 35a and coupled to a coupling screw 51. The coupling screw 51 may be coupled to the female screw hole 35e after passing through a screw hole 41a in the alignment mechanism 40 to maintain a coupled state of the alignment mechanism 40 and the penetration bulkhead 35. The testing device 30 shown in FIG. 7 has a feature that the alignment mechanism 40 may be separated. For example, the testing device 30 may be detachably attached. On the other hand, the alignment mechanism 40 shown in FIGS. 14 and 15 may be permanently fixed to the penetration bulkhead 35.

The alignment mechanism 40 is mounted on the penetration bulkhead 35 and may include a body 43, the nail guide 45, a strut 44, a pressing tip 47, and a flange 41.

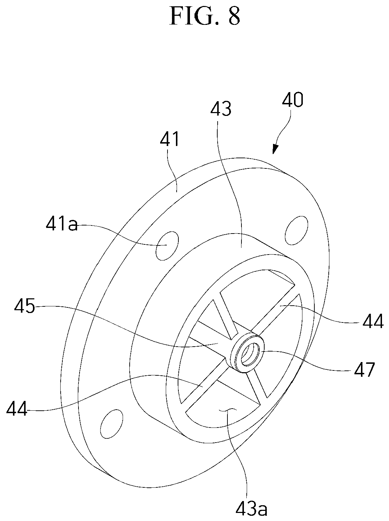

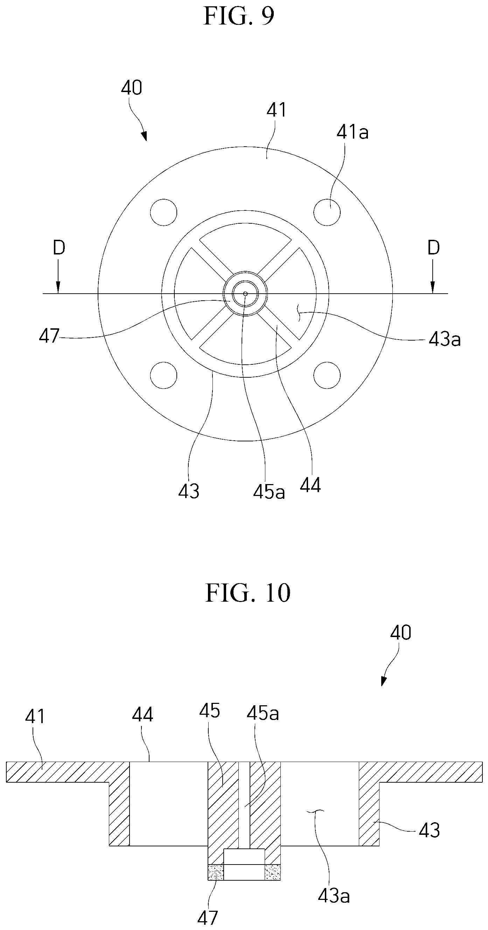

FIG. 8 is a perspective view of the penetration pin alignment mechanism 40 for a short-circuit test according to one embodiment of the present disclosure, FIG. 9 is a front view of the alignment mechanism shown in FIG. 8, and FIG. 10 is a cross-sectional view taken along the line D-D in FIG. 9.

The body 43 may have a cylindrical shape with a diameter (e.g., a predetermined diameter) and may be accommodated in the right-position recess 35a. An outer circumferential surface of the body 43 may come into surface contact with an inner circumferential surface of the right-position recess 35a. In addition, an end portion of the body 43 may come into contact with the bottom portion 35d of the right-position recess 35a. Therefore, the body 43 is restrained while being accommodated inside the right-position recess 35a and prevented from moving.

The flange 41 may be integrally formed with (or integrally formed from) an upper end portion of the body 43, may have a ring shape, and may have a plurality of screw holes 41a. As described above, the screw hole 41a may allow the coupling screw 51 to pass therethrough.

The nail guide 45 may have a guide passage 45a as a hollow member positioned at (or positioned along) a central axis portion of the body 43. The guide passage 45a may be a passage through which a nail main body 63 of the nail 60 passes. As shown in FIG. 11, the nail main body 63 may penetrate an electrode of the electrode assembly 15r after passing through the guide passage 45a. An end portion of the nail guide 45 may pass through the access hole 35c and the open hole 15t in the battery cell and extend into the case of the battery cell 15.

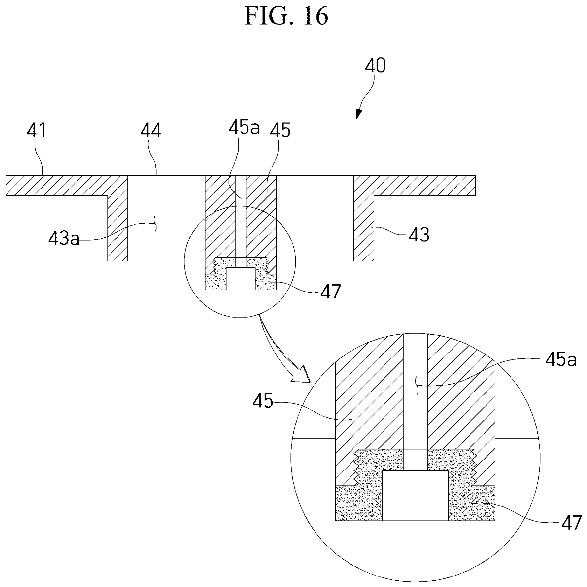

The pressing tip 47 is a ring-shaped member fixed to the end portion of the nail guide 45 and may press the electrode plate(s) of the electrode assembly 15r. The pressing tip 47 may be formed of an insulating material. For example, the pressing tip 47 may be formed of Teflon or engineering plastic. The pressing tip 47 for the nail guide 45 may be fixed by an adhesive method. However, the pressing tip 47 may be screw-coupled as shown in FIG. 16.

In addition, the strut 44 is a member connecting the body 43 with the nail guide 45. The strut 44 may be integrally formed with the body 43 and the nail guide 45. The strut 44 allows a heat dissipation passage 43a to be formed between the body 43 and the nail guide 45. The heat dissipation passage 43a may be a passage through which heat generated during the performance evaluation of the battery cell 15 is discharged externally. As long as the heat may be discharged, a shape of the heat dissipation passage 43a may be implemented in various ways.

The nail 60 may enter the battery cell 15 through the guide passage 45a and may cause an electrical short-circuit of the battery cell 15.

The nail 60 may include the nail main body 63 and a nail holder 61. The nail main body 63 may be a metal member that extends in a longitudinal direction and has a pointed front end. As shown in FIG. 11, the nail main body 63 may penetrate the electrode assembly 15r to electrically connect the positive electrode and the negative electrode to induce a short-circuit. A diameter of the nail main body 63 and a penetration depth are primary handling factors for a penetration safety evaluation. In the case of modern lithium-ion batteries for an electric vehicle, the diameter of the nail main body 63 may be about 1 mm and the penetration depth may be in a range from about 2 mm to about 3 mm.

The nail holder 61 is a member fixed to a rear end portion of the nail main body 63 and may act as a handle for a user to hold by hand.

FIG. 11 is a view illustrating a usage method of the secondary battery testing device 30 according to one embodiment of the present disclosure.

As shown, while the alignment mechanism 40 is mounted on the penetration bulkhead 35, the nail 60 completely enters the guide passage 45a in a direction of arrow f. Because the alignment mechanism 40 is coupled to the penetration bulkhead 35, the pressing tip 47 may press the electrode plate of the electrode assembly 15r.

In this way, swelling of the battery cell 15 can be suppressed or mitigated by the pressing of the electrode assembly 15r by the pressing tip 47. In addition, the support bulkhead 31 and the penetration bulkhead 35 can prevent expansion of the case 15a of the battery cell 15 by pressing the case 15a.

The nail main body 63 moves in the direction of arrow f to penetrate some electrode plates while the pressing tip 47 presses the electrode assembly 15r, thereby causing an internal short-circuit. According to the test specifications, the nail main body 63 may permeate or may completely penetrate the electrode plate of the electrode assembly to a predetermined depth (e.g., about 2 mm).

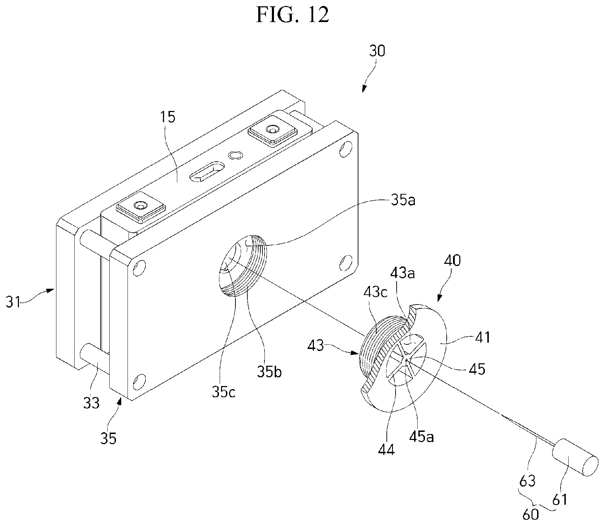

FIG. 12 is a cutout exploded perspective view of a secondary battery testing device according to another embodiment of the present disclosure, and FIG. 13 is a view illustrating a usage method of the testing device shown in FIG. 12.

Hereinafter, the same reference numerals as the above reference numerals denote the same members having the same functions, and repeated descriptions will be only briefly repeated or will be omitted.

As shown, a female screw portion 35b may be formed in the inner circumferential surface of the right-position recess 35a. The female screw portion 35b may be formed through mechanical machining (e.g., tapping) of the penetration bulkhead 35.

In addition, a male screw 43c may be formed on the outer circumferential surface of the body 43 of the alignment mechanism 40. The male screw 43c corresponds to the female screw portion 35b of the inner circumferential surface of the right-position recess 35a. Eventually, the alignment mechanism 40 may be screw-coupled to the penetration bulkhead 35. In addition, the alignment mechanism 40 may be separated from the penetration bulkhead 35. The alignment mechanism 40 may be used and replaced as needed.

When the alignment mechanism 40 is completely coupled to the right-position recess 35a, the end portion of the body 43 may come into surface contact with the bottom portion 35d of the right-position recess 35a, and in this state, the pressing tip 47 may press the electrode assembly 15r.

As described above, after the mounting of the alignment mechanism 40 is completed, the nail main body 63 may be inserted into the guide passage 45a of the nail guide 45 and may then enter the battery cell 15, thereby conducting an internal short-circuit test of the battery cell 15.

FIG. 14 is a view of a secondary battery testing device 30 according to another embodiment of the present disclosure, and FIG. 15 is a cross-sectional view of the penetration bulkhead shown in FIG. 14.

Referring to the drawings, the alignment mechanism 40 is completely inserted into the right-position recess 35a of the penetration bulkhead 35. The alignment mechanism 40 does not protrude externally (e.g., in a direction opposite to a direction facing the battery cell) of the penetration bulkhead 35. The right-position recess 35a may have a shape in which the alignment mechanism 40 may be completely accommodated. Because the alignment mechanism 40 does not protrude from the penetration bulkhead 35 in this way, the testing device 30 can be made slimmer.

In addition, as shown in FIG. 15, the pressing tip 47 may protrude downwardly with respect to a bottom surface of the penetration bulkhead 35. Because the pressing tip 47 protrudes downwardly in this way, the pressing tip 47 may pass through the open hole 15t in the battery cell and press the electrode assembly 15r.

FIG. 16 is a cross-sectional view of a penetration pin alignment mechanism 40 according to another embodiment of the present disclosure.

As shown, the pressing tip 47 may be screw-coupled to the nail guide 45. For example, a female thread may be machined at a lower end portion of the nail guide 45, and a male thread may be formed on the pressing tip 47 so that the pressing tip 47 may be screw-coupled to the nail guide 45.

Because the pressing tip 47 is screw-coupled to the nail guide 45, the mounting and separation of the pressing tip 47 is relatively easy. For example, after having pressing tips 47 of various sizes, the pressing tip 47 may be replaced with a size that is appropriate for a situation relatively easily. In addition, when the pressing tip 47 in use is damaged or worn out, the pressing tip 47 may be replaced with a new pressing tip 47.

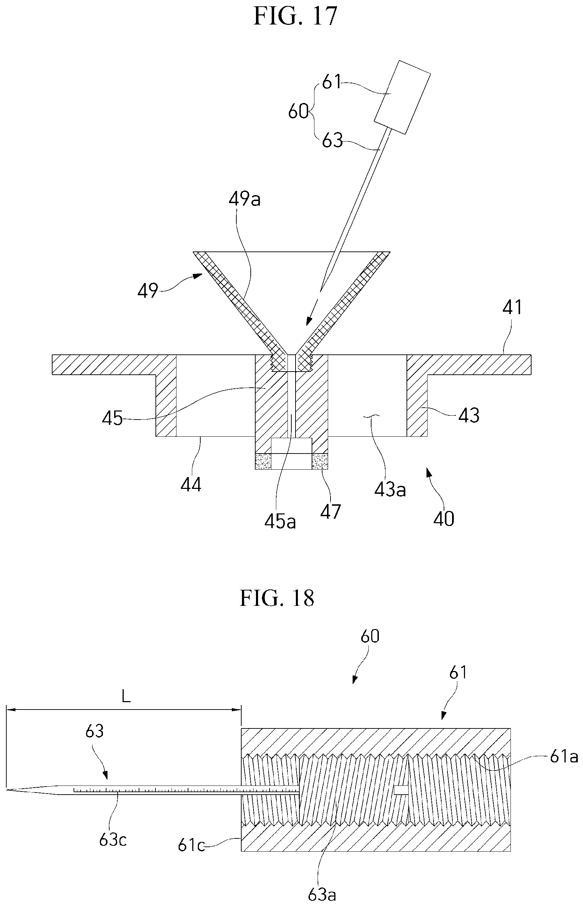

FIG. 17 is a cross-sectional view of a penetration pin alignment mechanism 40 according to another embodiment of the present disclosure.

As shown, an insert guide 49 may be additionally mounted on the upper end portion of the nail guide 45, based on the orientation of the drawing. The insert guide 49 may guide the insertion of the nail main body 63 into the guide passage 45a. For example, the insert guide 49 allows the nail main body 63 to be inserted more easily and quickly into the guide passage 45a.

For example, it may be difficult to insert the nail main body 63 having a diameter of about 1 mm into the guide passage 45a. IF the nail main body 63 is not inserted into the guide passage 45a at once, the nail main body 63 will inevitably hit the upper surface of the nail guide 45, and when such hitting is repeated, the nail 60 may be deformed, for example, bent. When the nail main body 63 is deformed, an angle of entry of the nail main body 63 into the electrode assembly 15r may be changed, causing test noise. The generated noise may interfere with an accurate penetration safety evaluation.

Table 1 (below) shows voltage values for normal penetration without noise on the left and abnormal penetration with noise on the right.

**TABLE 1**

| <Normal penetration> | <Abnormal penetration> |
|---|---|
| 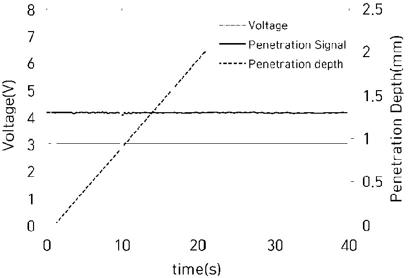 | 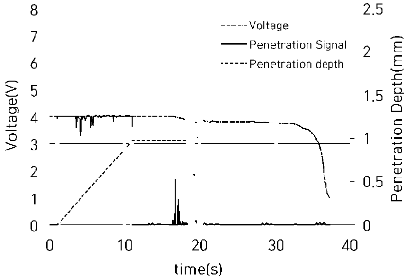 |

In the above Table 1, <Normal penetration> is a graph showing when the nail penetrates to a depth of 2 mm, and <Abnormal penetration> is a graph showing the occurrence of an event due to misalignment of the nail.

The insert guide 49 may be screw-coupled to the nail guide 45 and may be detachably attached. When the insert guide 49 is not necessary, the insert guide 49 may be separated. The insert guide 49 may be formed of a synthetic resin or metal.

The insert guide 49 has a shape of a funnel, for example, with an inner diameter that reduces (or narrows) toward the guide passage 45a. The nail main body 63 may move downwardly along an inner circumferential surface of the insert guide 49, that is, a guide inclined surface 49a, and may enter the guide passage 45a.

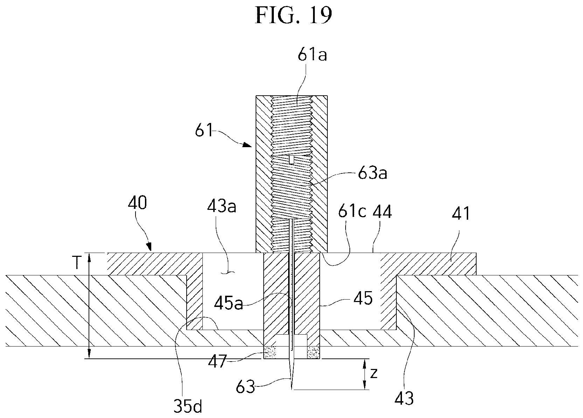

FIG. 18 is a cross-sectional view of a nail 60 applicable to the secondary battery testing device 30 according to an embodiment of the present disclosure, and FIG. 19 is a cross-sectional view illustrating a usage method of the nail shown in FIG. 18.

The nail 60 shown in FIG. 18 may have a structure including the nail main body 63, a screw head 63a, and the nail holder 61.

The screw head 63a may be a male screw member fixed to the rear end portion of the nail main body 63. The screw head 63a may be a set screw-type member having a male screw formed on an outer circumferential surface thereof.

In addition, the nail holder 61 may be a cylindrical hollow member having a female screw portion 61a formed on an inner circumferential surface thereof. The nail holder 61 may extend in the longitudinal direction of the nail main body 63 and may be screw-coupled to the screw head 63a. By axially rotating the nail main body 63 accommodated inside the nail holder 61, a protrusion length L of the nail main body 63 with respect to the nail holder 61 may be adjusted.

Reference numeral 61c denotes a close contact surface portion. The close contact surface portion 61c may be a portion that in close contact with the surface of the alignment mechanism 40 as shown in FIG. 19.

In addition, a scale 63c may be marked on the nail main body 63. The scale 63c may indicate the length L of the nail main body 63 protruding from the nail holder 61. The scale at (e.g., visible just adjacent to) the close contact surface portion 61c indicates the protrusion length L.

In addition, as shown in FIG. 19, because a thickness T from the upper surface to the lower end portion of the alignment mechanism 40 is known, a length Z of the nail main body 63 protruding downwardly from the pressing tip 47 of the nail main body 63 can be accurately calculated.

Eventually, because the degree of the nail main body 63 entering the electrode assembly 15r can be accurately adjusted by using the scale, thermal runaway patterns according to the depth of entry of the nail main body 63 can be observed in more detail.

A secondary battery testing device, according to embodiments of the present disclosure, can perform an accurate safety evaluation by preventing or avoiding misalignment in a penetration evaluation device of a battery.

In addition, a penetration pin alignment mechanism, according to embodiments of the present disclosure, can assist with center alignment of an open hole formed in a battery case and a nail and stably maintain horizontal penetration by preventing sagging of the nail due to its weight.

Aspects and features of the present disclosure are not limited to those described above, and other aspects and features not specifically mentioned herein will be clearly understood by those skilled in the art from the description of the present disclosure below.

Although the present disclosure has been described above with respect to embodiments thereof, the present disclosure is not limited thereto. Various modifications and variations can be made thereto by those skilled in the art within the spirit of the present disclosure as defined by the appended claims and their equivalents.

## Claims

1. A secondary battery testing device (30) comprising:
a support bulkhead (31) configured to contact one side surface of a battery cell (15) for an internal short-circuit test;
a penetration bulkhead (35) opposite to the support bulkhead (31) and configured to contact an opposite side surface of the battery cell (15), the penetration bulkhead (35) having an access opening extending therethrough toward the support bulkhead (31);
a bulkhead connector (33) connecting the support bulkhead (31) and the penetration bulkhead (35) to each other and maintaining a gap between the support bulkhead (31) and the penetration bulkhead (35);
an alignment mechanism (40) mounted on the penetration bulkhead (35) and having a nail guide (45) corresponding to the access opening and having a guide passage (45a); and
a nail (60) configured to penetrate the battery cell (15) through the guide passage (45a) to cause an electrical short-circuit of the battery cell (15).

2. The secondary battery testing device (30) as claimed in claim 1, wherein the penetration bulkhead (35) has a right-position recess (35a) configured to accommodate the alignment mechanism (40), the access opening being formed in an internal area of the right-position recess (35a).

3. The secondary battery testing device (30) as claimed in claim 2, wherein the right-position recess (35a) is a groove having an inner diameter, and
wherein the access opening is at a center of a bottom portion (35d) of the right-position recess (35a) and is configured to allow the nail guide (45) to pass therethrough.

4. The secondary battery testing device (30) as claimed in claim 2 or 3, wherein the alignment mechanism (40) further comprises a body (43) accommodated in the right-position recess (35a) and having the nail guide (45) at a central portion thereof.

5. The secondary battery testing device (30) as claimed in any of the preceding claims, wherein the nail guide (45) is configured to press an electrode plate of the battery cell (15) in a state in which the nail guide (45) passes through the access opening and an open hole (15t) in the battery cell (15).

6. The secondary battery testing device (30) as claimed in any of the preceding claims, wherein an end portion of the nail guide (45) is formed as a pressing tip (47) configured to press the electrode plate.

7. The secondary battery testing device (30) as claimed in any of claims 2 to 6, wherein the alignment mechanism (40) is detachably coupled to the right-position recess (35a) or is permanently fixed to the right-position recess (35a).

8. The secondary battery testing device (30) as claimed in any of the preceding claims, wherein the alignment mechanism (40) further comprises an insert guide (49) configured to guide insertion of the nail (60) into the guide passage (45a).

9. The secondary battery testing device (30) as claimed in any of the preceding claims, wherein the nail (60) comprises a nail main body (63) extending in a longitudinal direction and a nail holder (61) fixedly accommodating an end portion of the nail main body (63).

10. The secondary battery testing device (30) as claimed in claim 9, wherein the nail holder (61) comprises, at an inner side thereof, a screw head (63a) fixed to the end portion of the nail main body (63) and a male screw (43c) thread formed thereon, and
wherein the nail holder (61) is a hollow member extending in the longitudinal direction of the nail main body (63) and has a female screw portion (35b, 61a) screw-coupled to the screw head (63a).

11. A penetration pin alignment mechanism (40) for a secondary battery short-circuit test of any of the preceding claims, the penetration pin alignment mechanism (40) being configured to contact a battery cell (15) for an internal short-circuit test and being mounted on a penetration bulkhead (35) having an access opening formed to face the battery cell (15), the penetration pin alignment mechanism (40) comprising:
a nail guide (45) corresponding to the access opening and having a linearly extended guide passage (45a); and
a body (43) accommodating and supporting the nail guide (45).

12. The penetration pin alignment mechanism (40) as claimed in claim 11, wherein the penetration bulkhead (35) has a right-position recess (35a) having a diameter, the access opening being at a center of a bottom surface of the right-position recess (35a),
wherein the body (43) is fixedly accommodated in the right-position recess (35a), and
wherein the nail guide (45) extends into the battery cell (15) through the access opening and an open hole (15t) in the battery cell (15).

13. The penetration pin alignment mechanism (40) as claimed in claim 11 or 12, wherein a heat dissipation passage (43a) is formed between the body (43) and the nail guide (45).

14. The penetration pin alignment mechanism (40) as claimed in any of claims 11 to 13, wherein an end portion of the nail guide (45) has a pressing tip (47) configured to press an electrode plate inside the battery cell (15).

15. The penetration pin alignment mechanism (40) as claimed in any of claims 11 to **14,** further comprising an insert guide (49) configured to guide insertion of a nail (60) into the nail guide (45).
